Europäisches Patentamt

European Patent Office

Office européen des brevets

(11) Veröffentlichungsnummer: 0 492 074 A2

## EUROPÄISCHE PATENTANMELDUNG

(21) Anmeldenummer: 91117438.1

(22) Anmeldetag: 12.10.91

(51) Int. Cl.5: G11C 11/412

(30) Priorität: 21.12.90 DE 4041260

(43) Veröffentlichungstag der Anmeldung:
01.07.92 Patentblatt 92/27

(84) Benannte Vertragsstaaten:
AT BE DE DK ES FR GB GR IT NL SE

(71) Anmelder: MESSERSCHMITT-BöLKOW-BLOHM
GmbH
Postfach 80 11 09
W-8000 München 80(DE)

(72) Erfinder: Wipfelder, Werner
Berg-am-Laim-Strasse 71
W-8000 München 80(DE)

(54) Speicheranordnung mit einer Ausleseschaltung für eine statische Speicherzelle.

(57) Speicheranordnung mit statischer Speicherzelle mit zwei Transistoren, wobei dem einen Transistor das Eingangssignal zum Setzen der Speicherzelle zugeführt wird und der Ausgang des anderen Transistors mit dem Eingang des ersten Transistors verbunden ist, so daß immer ein Transistor leitet und der andere sperrt, wobei die beiden Transistoren (1, 12) komplementäre MOS-Feldeffekt-Transistoren sind, die in Mitkoppelung geschaltet sind, daß die Gate-Elektrode (G) je an einer Spannung, insbesondere der halben Batteriespannung anliegt (UB/2), daß die Source-Elektrode des ersten (N-Kanal-)Transistors (1) den Eingang der Speicherzelle bildet, daß die Drain-Elektrode (D) dieses ersten Transistors (1) mit der Source-Elektrode (16) des zweiten (P-Kanal-)Transistors (12) verbunden ist, daß die Drain-Elektrode (17) des zweiten Transistors (12) auf die Source-Elektrode (S) des ersten Transistors zurückgeführt ist und daß der Sperrwiderstand der Diode Drain - Substrat des ersten Transistors größer ist als der Sperrwiderstand der Diode Source - Substrat des zweiten Transistors und daß ferner die Ausgangsspannung ($U_{ANS}$) des ersten (N-Kanal-)Transistors (1) größer ist als die Summe aus Gate-Spannung ($U_G$) und Schwellenspannung ($U_{TH}$) des zweiten (P-Kanal-)Transistors (12).

FIG.5

EP 0 492 074 A2

Die Erfindung bezieht sich auf eine Speicheranordnung gemäß dem Oberbegriff des Patentanspruches 1.

Einfache statische Speicherzellen sind z.B. Flip-Flops, die aus zwei rückgekoppelten Transistoren aufgebaut sind und zwei definierte Betriebszustände haben, in denen jeweils einer der Transistoren leitend und der andere gesperrt ist. Vom einen auf den anderen stabilen Betriebszustand kann das Flip-Flop durch einen Eingangsimpuls an einen der beiden Transistoren, den Eingangstransistor, umgeschaltet werden.

Eine in dem US-Patent 4 158 239 als Re 32,071 beschriebene Speicherzelle weist einen hohen Leistungs- und Platzbedarf auf.

Für Speicherzellen mit Transistoren müssen neben diesen Transistoren noch andere Bauelemente, insbesondere Widerstände eingesetzt werden, um die Betriebsparameter der Transistoren aneinander anzupassen. Diese zusätzlichen Bauelemente müssen mit den Transistoren noch über Verbindungsleitungen verschaltet werden, so daß sich insgesamt ein recht hoher Schaltungsaufwand ergibt, der insbesondere bei einer Integrierung der Speicherzelle auf Halbleiterchips bedeutend wird: Bei derartigen integrierten Speicherzellenanordnungen versucht man, den Platzbedarf für die einzelnen Speicherzellen und auch für die Verbindungen dieser einzelnen Speicherzellen möglichst klein zu halten, um auf diese Weise eine möglichst große Anzahl von Speicherzellen auf dem Halbleiterchip integrieren zu können.

Der Erfindung liegt die Aufgabe zugrunde, eine Speicheranordnung der in Rede stehenden Art anzugeben, die mit einem nur geringen Schaltungsaufwand auch hinsichtlich zusätzlicher Bauelemente realisiert werden kann, so daß die Speicheranordnung nur geringe Ausmaße hat und daß eine Vielzahl von Speicherzellen auf einem Halbleiterchip integriert werden können.

Diese Aufgabe ist gemäß der Erfindung durch die im kennzeichnenden Teil des Patentanspruches 1 angegebenen Merkmale gelöst.

Demgemäß besteht der wesentliche Erfindungsgedanke darin, die Speicherzelle aus zwei komplementären Transistoren, vorzugsweise MOS-Feldeffekttransistoren, aufzubauen, die ohne weitere Bauelemente direkt miteinander in Mitkoppelung geschaltet sind, so daß der Ausgang jedes Transistors direkt mit dem Eingang des anderen Transistors verbunden ist.

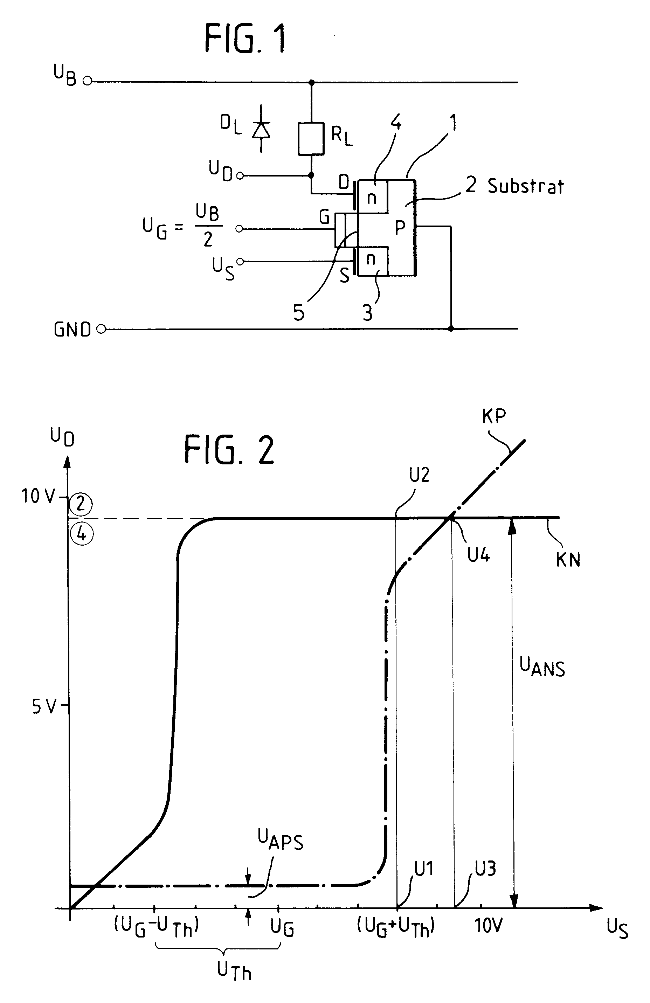

Die statische Speicherzelle gemäß der Erfindung hat zwei stabile Betriebszustände (vgl. Fig. 2), wobei das Ausgangssignal z.B. am Ausgang des zweiten Transistors abgenommen werden kann und dann gemäß dem jeweiligen Betriebszustand ein HOCH- bzw. NIEDRIG-Signal, d.h. in digitaler Schreibweise ein EINS- bzw. NULL-Signal ist.

Die statische Speicherzelle gemäß der Erfindung wird durch ein impulsförmiges EINS- bzw. NULL-Signal über einen Treiber, vorzugsweise einen Tri-State-Treiber angesteuert, wodurch die Speicherzelle gesetzt wird.

Die Erfindung ist in Ausführungsbeispielen anhand der Zeichnung näher erläutert. In der Zeichnung stellen dar:

Fig. 1     eine Schaltung eines N-Kanal-MOS-Feldeffekttransistors, der an der Source-Elektrode angesteuert wird;

Fig. 2     die Kennlinie des Transistors gemäß Fig. 1, aufgetragen als Ausgangsspannung an der Drain-Elektrode über der der Source-Elektrode zugeführten Eingangsspannung sowie eine Kennlinie für einen entsprechenden komplementären P-Kanal-MOSFET;

Fig. 3     eine Schaltung einer statischen Speicherzelle gemäß der Erfindung mit zwei komplementären MOS-Feldeffekttransistoren;

Fig. 4     ein Strom/Spannungs-Kennliniendiagramm für zwei, durch die pn-Übergänge der Feldeffekttransistoren gebildete Dioden zweier unterschiedlicher Transistoren;

Fig. 5     eine Speicheranordnung mit einer Ausleseschaltung und

Fig. 6     eine Vielzahl von Speicherzellen gemäß der Erfindung, die in einer Matrix aus Daten- und Wortleitungen integriert angeordnet sind.

In Fig. 1 ist ein npn-MOS-Transistor 1, d.h. ein N-Kanal-MOSFET mit seinem p-dotierten Substrat 2 und den n-dotierten Source- und Drain-Bereichen 3 bzw. 4 sowie dem Gate-Bereich 5 dargestellt. Diesen Bereichen sind eine Source-Elektrode S, eine Drain-Elektrode D und eine Gate-Elektrode G zugeordnet. Das Substrat 2 liegt auf einem Grundpotential GND, z.B. Null Volt. Der Source-Elektrode S wird das Eingangssignal als Spannung $U_S$ zugeführt, die Gate-Elektrode G liegt an der Spannung $U_G$, die z.B. dem halben Wert der Batteriespannung $U_B$, d.h. $U_B/2$ entspricht, während an der Drain-Elektrode D die Ausgangsspannung $U_D$ abgegriffen werden kann. Die Drain-Elektrode D ist über einen Lastwiderstand $R_L$ mit einer die Batteriespannung $U_B$ führenden Leitung verbunden. Der Lastwiderstand $R_L$ kann durch die Diode $D_L$ ersetzt werden, vorausgesetzt, daß die in Sperrichtung liegende Diode entsprechend dem pn-Übergang zwischen Drain und Substrat hochohmiger als die ebenfalls in Sperrichtung liegende Diode $D_L$ ist.

Diese Schaltung hat die in Fig. 2 gezeigte Kennlinie KN, aufgetragen als Ausgangsspannung $U_D$ an der Drain-Elektrode über der Eingangsspannung $U_S$ an der Source-Elektrode. Steigt die Eingangsspannung $U_S$ an der Source-Elektrode ausgehend von dem Wert Null Volt, so folgt die Ausgangsspannung $U_D$ an der Drain-Elektrode der Eingangsspannung im wesentlichen linear, solange die Spannungsdifferenz zwischen Gate-Elektrode und Source-Elektrode größer als die Schwellenspannung $U_{Th}$ des Transistors ist. Der Transistor ist somit leitend. Die Strecke zwischen dem Source-Bereich und dem Drain-Bereich 4 des MOSFET ist wesentlich niederohmiger als die Last $R_L$ bzw. $D_L$ und niederohmiger als der in Sperrichtung liegende pn-Übergang zwischen Source-Bereich 3 und Substrat 2. Wenn die Eingangsspannung weiter steigt, so wird die Steuerspannung des MOSFET entsprechend der Differenz $(U_G - U_S)$ kleiner als die Schwellenspannung $U_{Th}$, so daß der Transistor sperrt. Die Ausgangsspannung des Transistors steigt dabei bis auf einen Endwert $U_{ANS}$ an. Die Höhe dieser Ausgangsspannung wird im wesentlichen durch den Spannungsteiler, bestehend aus $R_L$ bzw. $D_L$ und der Diode zwischen dem Drain-Bereich 4 und dem Substrat 2 festgelegt.

Ersetzt man in Fig. 1 den N-Kanal-MOSFET durch einen P-Kanal-MOSFET, so führt dieses zu der strichpunktiert gezeichneten Linie KP in Fig. 2. Der P-Kanal-MOSFET bleibt bei Zuführen der Eingangsspannung $U_S$ an der Source-Elektrode gesperrt und wird erst leitend, wenn die Eingangsspannung $U_S$ die Summe der Gate-Spannung $U_G$ und der Schwellenspannung $U_{Th}$ überschreitet.

Für das Kennliniendiagramm gemäß Fig. 2 wurde ein N-Kanal-MOSFET zugrundegelegt, der bei einer Eingangsspannung $U_S$ von etwa zwei Volt gesperrt wird, und ein P-Kanal-MOSFET, der ab etwa acht Volt leitend wird.

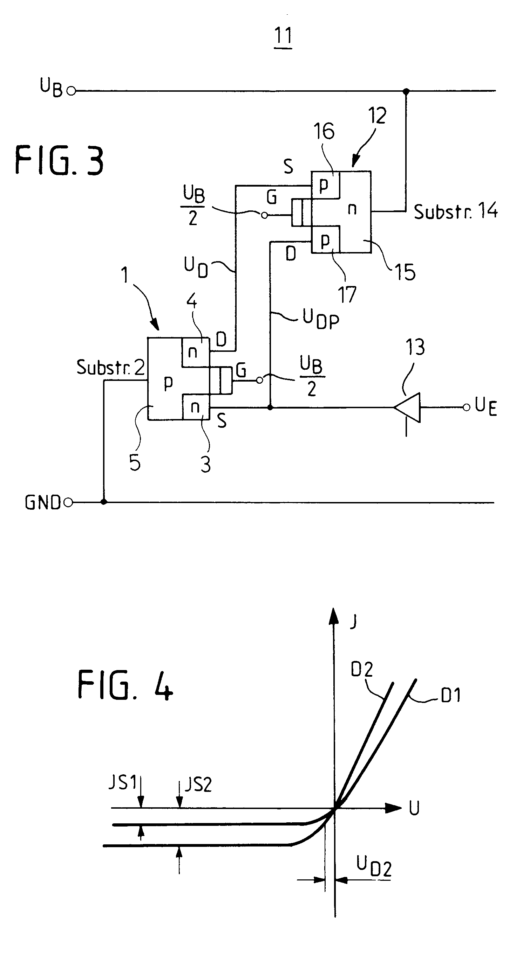

In Fig. 3 ist die Schaltung einer statischen Speicherzelle 11 mit einem N-Kanal-MOSFET 1 entsprechend Fig. 1 und einem P-Kanal-MOSFET 12 dargestellt. Das Substrat 2 des Transistors 1 liegt auf Grundpotential GND, die Gate-Elektrode G an der halben Batteriespannung, der Source-Elektrode S wird das zu speichernde Eingangssignal $U_E$ über einen Tri-State-Treiber 13 zugeführt, während an der Drain-Elektrode die Ausgangsspannung $U_D$ abgegriffen werden kann. Die Drain-Elektrode 4 ist mit der Source-Elektrode 16 des zweiten Transistors 12 verbunden. Die Drain-Elektrode 17 des zweiten Transistors 12 ist mit der Source-Elektrode 3 des ersten Transistors 1 verbunden. Die Gate-Elektrode $G_P$ des zweiten Transistors 12 liegt ebenfalls an der halben Batteriespannung $U_B/2$.

Bei dieser Schaltung einer Speicherzelle sind keine externen Bauelemente mehr notwendig. Die in Sperrichtung geschaltete Diode zwischen Source und Substrat des einen Transistors ist jeweils die Last des anderen Transistors. Die Ausgangsspannung $U_D$ des ersten Transistors ist die Eingangsspannung für den zweiten Transistor, wohingegen dessen an der Drain-Elektrode $D_P$ anliegende Ausgangsspannung $U_{DP}$ als Eingangsspannung dem ersten Transistor an der Source-Elektrode zugeführt wird. Ist die jeweilige Diode zwischen Drain und Substrat eines Transistors, die hier in Sperrichtung liegt, hochohmiger als die jeweilige Diode zwischen Source und Substrat des anderen Transistors, so gelten auch die Kennlinien $K_N$ bzw. $K_P$ entsprechend Fig. 2 für die beiden Transistoren 1, 12.

Legt man zum Einschreiben der Speicherzellen an den Treiber 13 als Eingangssignal ein HOCH- bzw. EINS-Signal von z.B. acht Volt, entsprechend dem in Fig. 2 eingezeichneten Spannungswert U1, und schaltet man anschließend den Treiber 13 in den hochohmigen Zustand, so sperrt der N-Kanal-MOSFET 1 und liefert eine Ausgangsspannung U2 entsprechend der Spannung $U_{ANS}$ im gesperrten Zustand. Diese Ausgangsspannung ist Eingangsspannung für den komplementären P-Kanal-MOSFET 12; vgl. die Spannung U3. Der leitende P-Kanal-MOSFET 12 liefert eine Ausgangsspannung entsprechend U4 in Fig. 2, die wiederum Eingangsspannung für den ersten N-Kanal-MOSFET 1 ist und diesen weiterhin gesperrt hält. Der durch ein impulsförmiges Eingangssignal $U_E$ eingerichtete stabile Betriebszustand bleibt dadurch statisch gespeichert (durchgezogene Linie U4 in Fig. 2 oben).

Legt man an den Eingang der Speicherzelle die Eingangsspannung Null Volt, so vertauschen die Transistoren ihre Rollen und man erhält den zweiten stabilen Zustand der Speicherzelle, in der der erste Transistor 1 leitet und der zweite komplementäre Transistor 12 gesperrt ist. Dieser zweite stabile Betriebszustand liegt etwa beim Schnittpunkt der beiden Kennlinien KN und KP im unteren Spannungsbereich $U_{APS}$ (strichpunktierte Linie in Fig. 2 unten).

Für das Funktionieren dieser Schaltung ist wichtig, daß die Ausgangsspannung $U_{ANS}$ des gesperrten ersten Transistors 1 größer ist als die Summe der Spannungen $U_G$ und $U_{Th}$ und ferner, daß die Ausgangsspannung $U_{APS}$, des gesperrten zweiten komplementären Transistors kleiner ist als $(U_G - U_{Th})$, so daß die Ausgangsspannung des jeweils sperrenden Transistors den anderen Transistor im linearen Bereich der Kennlinie entsprechend dem leitenden Zustand betreibt.

Wie oben erläutert, muß die Diode entsprechend dem Übergang zwischen Drain und Substrat des einen Transistors hochohmiger als die jeweils angeschlossene Diode entsprechend dem Übergang zwischen Source und Substrat des anderen Transistors sein. Der Sperrstrom $J_S$ einer Diode hängt nun von der Fläche des entsprechenden pn-Überganges ab. Hierdurch ist es möglich, durch Dimensionierung dieser Fläche den Widerstand einer gesperrten Diode so zu dimensionieren, daß die jeweiligen Dioden am Übergang Source-Substat niederohmiger sind als die angeschlossenen Dioden am Übergang zwischen Drain und Substrat.

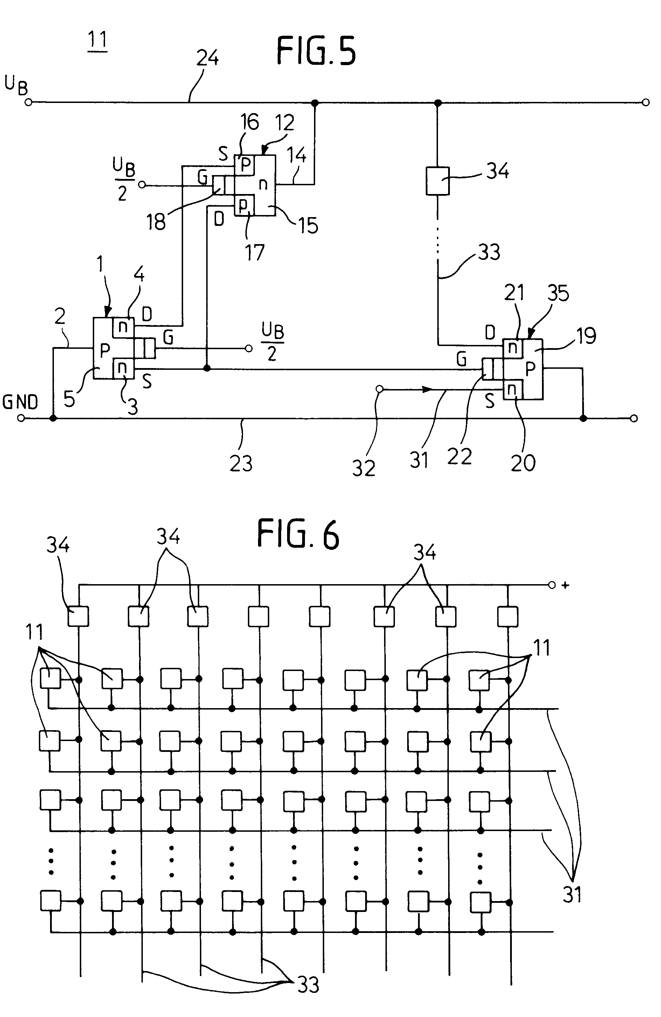

In Fig. 4 sind die Kennlinien zweier unterschiedlicher Dioden D1 und D2 dargestellt, wobei der Sperrstrom der ersten Diode mit $J_S1$ und der Sperrstrom der zweiten Diode mit $J_S2$ bezeichnet ist. Setzt man voraus, daß die beiden Feldeffekttransistoren gleiches Substrat aufweisen und nach dem gleichen Verfahren hergestellt wurden, und hat die Diode D2 eine größere Fläche am pn-Übergang als die Diode D1, so weist diese Diode D2 auch den größeren Sperrstrom auf. Da diese beiden Dioden bei der Schaltung gemäß Fig. 3 in Reihe geschaltet sind, fließt durch sie der Strom $J_S1$. Dies erzeugt an der Diode D2 einen Spannungsabfall $U_{D2}$, wo- hingegen die restliche Spannung an der Diode 1 liegt. Durch die Maßnahme unterschiedlicher Dimensionierung der pn-Übergänge ist es somit möglich, die obige Forderung hinsichtlich der Widerstandswerte an diesen Übergängen zu erfüllen.

Die statische Speicherzelle 11 ist aus zwei in Mitkopplung geschalteten komplementären MOS-Feldeffekttransistoren 1, 12 aufgebaut, wobei die Source-Elektrode des ersten (N-Kanal-)Transistors den Eingang der Speicherzelle bildet, die Drain-Elektrode des ersten Transistors mit der Source-Elektrode des zweiten (P-Kanal-)Transistors verbunden und die Drain-Elektrode des zweiten Transistors auf die Source-Elektrode des ersten Transistors zurückgeführt ist. Das p-Substrat des ersten Transistors ist mit einer Massenleitung verbunden, das n-Substrat mit einer die Batterie- bzw. Versorgungsspannung führenden Leitung. Die Gate-Bereiche der beiden Transistoren liegen an der halben Batteriespannung.

Für eine Speicheranordnung mit statischer Speicherzelle der vorbeschriebenen Art wird nachstehend eine Ausleseschaltung angegeben, die mit einem nur geringen Aufwand realisiert werden kann, so daß die Informationen aus der Speicherzelle problemlos ausgelesen werden können.

Bei der Erfindung wird gemäß Patentanspruch 4 hierzu ein dritter MOS-Feldeffekttransistor vom N-Kanal-Typ vorgesehen, dessen Gate-Elektrode mit der Source-Elektrode des ersten (N-Kanal-)Transistors, dessen Source-Elektrode mit einer ein Schreibsignal führenden Wortleitung und dessen Drain-Elektrode über eine Datenleitung mit einem Lastwiderstand verbunden ist.

Hierbei ist es möglich, die neue Speicheranordnung mit Ausleseschaltung durch lediglich einen einzigen Transistor und einen Lastwiderstand zu realisieren. Der dritte Transistor ist gesperrt, wenn über die Wortleitung an der Source-Elektrode ein HOCH-Signal anliegt, und leitet, wenn dieses Signal ein NIEDRIG-Signal ist. Wenn der dritte Transistor gesperrt ist, so liegt am Ausgang dieses Transistors ein Signal an, das unabhängig vom Inhalt der Speicherzelle ist. Wird dieser dritte Transistor über die Source-Elektrode zum Auslesen angesteuert, so erscheint am Ausgang dieses Transistors die Information der Speicherzelle, allerdings in invertierter Form. Diese Information kann über die Datenleitung abgenommen werden. Durch den hohen Widerstand des Gatebereiches des dritten MOS-Transistors ist zudem gewährleistet, daß die statische Speicherzelle den dritten Transistor treiben kann. Durch die Beschaltung dieses dritten Transistors und durch dessen Fähigkeiten als Treiberstufe für die Speicherzelle erhält man auch auf einer ausgedehnten Datenleitung stets ein brauchbares Signal.

Die angegebene Schaltung ermöglicht auch das problemlose Treiben von Lasten, so z.B. Leitungen bei integrierten Schaltungen.

Die statische Speicherzelle 11 weist nach Fig. 5 einen ersten N-Kanal MOS-FET 1, einen zweiten P-Kanal MOS-FET 12 und als Auslesetransistor einen dritten N-Kanal MOS-FET 35 auf. Der erste Transistor 1 hat in bekannter Weise ein Substrat 2, eine Source-Elektrode 3, eine Drain-Elektrode 4 sowie eine Gate-Elektrode 5. Die entsprechenden Bereiche Substrat, Drain D, Source S und Gate G sind für den zweiten MOS-FET-Transistor 12 mit 15, 16, 17 und 18 sowie für den dritten MOS-FET-Transistor 35 mit 19, 20, 21 bzw. 22 bezeichnet. Das Substrat 2 des ersten Transistors 1 ist ebenso wie das Substrat 19 des dritten Transistors mit einer ein Referenzpotential, hier das Grundpotential GND führenden Masseleitung 23 verbunden, das Substrat 15 des zweiten Transistors 12 ist mit einer Versorgungsleitung 24 verbunden, die an der Versorgungs- bzw. Batteriespannung $U_B$ liegt. Die Gate-Elektroden G und 18 der beiden ersten Transistoren 1 und 12 liegen jeweils an der halben Batteriespannung. Ansonsten sind diese beiden Transistoren 1 und 12 in Mitkopplung geschaltet, d.h., daß die Drain-Elektrode 4 des ersten Transistors 1 mit der Source-Elektrode 16 des zweiten Transistors 12 und dessen Drain-Elektrode 17 mit der Source-Elektrode 3 des ersten Transistors verbunden ist. Die Source-Elektrode 3 des ersten Transistors dient als Ausgang der Speicherzelle und ist mit der Gate-Elektrode 22 des dritten Transistors 35 verbunden.

Die Source-Elektrode 20 dieses dritten Transistors 35 ist mit einer Wortleitung 31 verbunden, die zu einem Schreibanschluß 32 führt. Die Drain-Elektrode 21 des dritten Transistors 35 ist über eine Datenleitung 33 mit einem Lastwiderstand 34 verbunden, der seinerseits an die Versorgungsleitung 24 angeschlossen ist.

Hinsichtlich der Dimensionierung der beiden Speicher-Transistoren 1 und 12 wird auf die Beschreibung zu Fig. 3 verwiesen. Die jeweils durch einen pn-Übergang gebildete, in Sperrichtung liegende Diode zwischen Drain und Substrat eines Transistors muß hochohmiger sein als die durch den pn-Übergang des jeweils anderen Transistors gebildete Diode zwischen Source und Substrat. Dies kann z.B. durch eine entsprechende Dimensionierung der Flächen der jeweiligen pn-Übergänge erfolgen.

Außerdem ist für das Funktionieren der Schaltung wichtig, daß die Ausgangsspannung des gesperrten ersten (N-Kanal-)Transistors 1 größer ist als die Summe aus Gatespannung und Schwellenspannung des zweiten (P-Kanal-)Transistors und ferner, daß die Ausgangsspannung bei gesperrtem zweiten (P-Kanal-)Transistor 12 kleiner ist als die Differenz zwischen der Gatespannung und der Schwellenspannung des ersten (N-Kanal-)Transistors 1. Hierdurch wird sichergestellt, daß die Ausgangsspannung des jeweils sperrenden Speichertransistors den anderen Transistor im leitenden Zustand im linearen Bereich von dessen Kennlinie betreibt.

Zum Einschreiben der Speicherzelle wird entsprechend der Fig. 3 über eine Treiberschaltung an die Source-Elektrode 3 des ersten Transistors ein HOCH- bzw. EINS-Signal von z.B. 8 Volt angelegt. Schaltet man anschließend die Treiberschaltung in den hochohmigen Zustand, so sperrt der erste (N-Kanal-)Transistor 1. Dessen Ausgangsspannung ist Eingangsspannung für den komplementären zweiten Transistor 12, dessen Ausgangsspannung seinerseits wiederum als Eingangspannung für den ersten Transistor 1 dient und diesen weiterhin gesperrt hält. Der durch ein impulsförmiges Eingangssignal eingerichtete Betriebszustand bleibt somit statisch gespeichert.

Zum Auslesen dient der dritte Transformator 35. Liegt an der Wortleitung 31 ein HOCH- bzw. EINS-Signal, so sperrt dieser dritte Transistor 35 und an dessen Ausgang liegt unabhängig vom Informationsinhalt der Speicherzelle ein HOCH-Signal an. Wird das Signal auf der Wortleitung 31 auf NIEDRIG oder NULL geschaltet, so erscheint am Ausgang, d.h. an der Drain-Elektrode 21 des dritten Transistors die in den beiden Speichertransistoren 1 und 2 gespeicherte Information, allerdings in invertierter Form. Diese Information kann in herkömmlicher Weise an der Datenleitung 33 über den Lastwiderstand 34 abgenommen werden.

Durch den hohen Widerstand der Gate-Elektrode des Transistors 35 kann die Speicherzelle aus den Speichertransistoren 1 und 12 auch diesen dritten Auslesetransistor 35 treiben.

In Fig. 5 ist die Datenleitung 33 zwischen der Drain-Elektrode 21 des dritten Transistors 3 und dem Lastwiderstand 34 gestrichelt dargestellt. Hiermit soll angedeutet werden, daß es vorteilhaft ist, wenn eine Vielzahl derartiger Speicherzellen, wie in Fig. 6 gezeigt, in einem Matrixverband aus Daten- und Wortleitungen 33 bzw. 31 angeordnet wird, wobei jeweils die Anschlüsse der Wortleitungen 31 aller Speicherzellen in einer Zeile und die Anschlüsse der Datenleitungen 33 in einer Spalte zusammengefaßt sind. Jeder Lastwiderstand 34 ist in einem solchen Fall gemeinsamer Lastwiderstand für alle in einer Spalte angeordneten Speicherzellen.

## Patentansprüche

1. Speicheranordnung mit statischer Speicherzelle mit zwei Transistoren, wobei dem einen Transistor das Eingangssignal zum Setzen der Speicherzelle zugeführt wird und der Ausgang des anderen Transistors mit dem Eingang des ersten Transistors verbunden ist, so daß immer ein Transistor leitet und der andere sperrt, **dadurch gekennzeichnet,** daß die beiden Transistoren (1, 12) komplementäre MOS-Feldeffekt-Transistoren sind, die in Mitkoppelung geschaltet sind, daß die Gate-Elektrode (G) je an einer Spannung, insbesondere der halben Batteriespannung anliegt (UB/2), daß die Source-Elektrode des ersten (N-Kanal-)Transistors (1) den Eingang der Speicherzelle bildet, daß die Drain-Elektrode (D) dieses ersten Transistors (1) mit der Source-Elektrode (16) des zweiten (P-Kanal-)Transistors (12) verbunden ist, daß die Drain-Elektrode (17) des zweiten Transistors (12) auf die Source-Elektrode (S) des ersten Transistors zurückgeführt ist und daß der Sperrwiderstand der Diode Drain - Substrat des ersten Transistors größer ist als der Sperrwiderstand der Diode Source - Substrat des zweiten Transistors und daß ferner die Ausgangsspannung ($U_{ANS}$) des ersten (N-Kanal-)Transistors (1) größer ist als die Summe aus Gate-Spannung ($U_G$) und Schwellenspannung ($U_{TH}$) des zweiten (P-Kanal-)Transistors (12).

2. Speicheranordnung nach Anspruch 2, **dadurch gekennzeichnet,** daß die Flächen der jeweiligen pn-Übergänge zwischen Source und Substrat größer sind als die Flächen der jeweiligen pn-Übergänge zwischen Drain und Substrat des jeweilig anderen Transistors.

3. Speicheranordnung nach einem der vorhergehenden Ansprüche, **dadurch gekennzeichnet,** daß die Ausgangsspannung ($U_{APS'}$) bei gesperrtem (P-Kanal-)Transistor (12) kleiner als die Differenz zwischen der Gate-Spannung ($U_G$) und der Schwellenspannung ($U_{Th}$) des (N-Kanal-)Transistors (1) ist, so daß die Ausgangsspannung des jeweils sperrenden Transistors den anderen Transistor im leitenden Zustand im linearen Bereich von dessen Kennlinie (KN, KP) betreibt.

4. Speicheranordnung mit einer Ausleseschaltung für eine statische Speicherzelle aus Zwei in Mitkopplung geschalteten komplementären MOS-Feldeffekttransistoren, wobei die Drain-Elektrode des ersten (N-Kanal)-Transistors mit der Source-Elektrode des zweiten (P-Kanal-)Transistors verbunden und die Drain-Elektrode des zweiten Transistors auf die Source-Elektrode des ersten Transistors zurückgeführt ist, **dadurch gekennzeichnet,** daß zum Auslesen der Speicherzelle (11) ein dritter MOS-Feldeffekttransistor (35) vom N-Kanal-Typ vorgesehen ist, dessen Gate-Elektrode (22) mit der Source-Elektrode (S) des ersten (N-Kanal-)Transistors (1), dessen Source-Elektrode (20) mit einer ein Schreibsignal führenden Wortleitung (31) und dessen Drain-Elektrode (21) über eine Datenleitung (33) mit einem Lastwiderstand (34) verbunden ist.

5. Speicheranordnung mit einer Ausleseschaltung nach Anspruch 4, **dadurch gekennzeichnet,** daß eine Vielzahl derartiger Speicherzellen (11) in einem matrixartigen Verband aus Datenleitungen (33) und Wortleitungen (31) angeordnet sind, und daß ein Lastwiderstand (34) für sämtliche Speicherzellen (11) einer Spalte vorgesehen ist.

# FIG. 1

$U_B$

$D_L$  $R_L$

$U_D$

D  4  1

n

$U_G = \dfrac{U_B}{2}$  G  2 Substrat

P

$U_S$

S  n

5  3

GND

# FIG. 2

$U_D$  KP

U2

10 V — ②

④  U4  KN

$U_{ANS}$

5 V —

$U_{APS}$

U1  U3

$(U_G - U_{Th})$  $U_G$  $(U_G + U_{Th})$  10V  $U_S$

$U_{Th}$

<u>11</u>

U_B○

FIG. 3

S  16  12

G  P  n

$\frac{U_B}{2}$  Substr. 14

U_D  D  15

1  P  17

4  U_DP

D  n

Substr. 2  P  $\frac{U_B}{2}$  13

G

n  S  U_E

5  3

GND○

FIG. 4

J

D2  D1

JS1  JS2

U

U_D2

# FIG.5

# FIG.6